# EUROPÄISCHE PATENTSCHRIFT

(11) **EP 2 329 477 B1**
(45) Veröffentlichungstag und Bekanntmachung des Hinweises auf die Patenterteilung: **22.06.2016**
(21) Anmeldenummer: 09736802.1
(22) Anmeldetag: 01.09.2009
(51) Int. Cl.: G08G 1/095, G09F 9/33, H01L 25/075, H01L 33/60

(54) **OPTOELEKTRONISCHES BAUTEIL**
OPTOELECTRONIC COMPONENT
COMPOSANT OPTOÉLECTRONIQUE

(30) Priorität: 25.09.2008 DE 102008048846
(43) Veröffentlichungstag der Anmeldung: 08.06.2011
(73) Patentinhaber: OSRAM Opto Semiconductors GmbH, 93055 Regensburg (DE)
(72) Erfinder: BRICK, Peter, 93051 Regensburg (DE); ZITZLSPERGER, Michael, 93047 Regensburg (DE); WEBER-RABSILBER, Sven, 93073 Neutraubling (DE)
(74) Vertreter: Epping - Hermann - Fischer
(86) Internationale Anmeldenummer: PCT/DE2009/001228
(87) Internationale Veröffentlichungsnummer: WO 2010/034281

(56) Entgegenhaltungen:
- WO-A1-2004/068447
- WO-A2-2007/058955
- DE-A1-102005 059 524
- DE-U1- 9 417 326
- JP-A- 2000 299 502
- US-A1- 2006 138 440
- US-A1- 2006 175 626
- US-B2- 6 886 962

## Beschreibung

Es wird ein optoelektronisches Bauteil angegeben.

Die Druckschriften, US2006/0138440 A1, US2006/175626 A1 und DE 102005001954 A1 beschreiben jeweils ein optoelektronisches Bauteil.

Eine zu lösende Aufgabe besteht darin, ein optoelektronisches Bauteil anzugeben, das besonders gut gegen Umwelteinflüsse wie Fremdlichteinstrahlung und/oder Regenwasser geschützt ist. Eine weitere zu lösende Aufgabe besteht darin, ein optoelektronisches Bauteil anzugeben, das besonders einfach montiert werden kann.

Die Aufgabe wird durch ein optoelektronisches Bauteil gemäß Anspruch 1 gelöst.

Gemäß zumindest einer Ausführungsform des optoelektronischen Bauteils umfasst das Bauteil zumindest einen Lumineszenzdiodenchip. Bei dem Lumineszenzdiodenchip handelt es sich vorzugsweise um einen Laserdiodenchip oder einen Leuchtdiodenchip. Im Betrieb des optoelektronischen Bauteils ist der Lumineszenzdiodenchip zur Erzeugung elektromagnetischer Strahlung geeignet. Die elektromagnetische Strahlung kann dabei im Wellenlängenbereich von UV-Strahlung bis Infrarotlicht liegen. Beispielsweise ist der Lumineszenzdiodenchip zur Erzeugung von elektromagnetischer Strahlung im sichtbaren Spektralbereich geeignet.

Gemäß zumindest einer Ausführungsform des optoelektronischen Bauteils umfasst das Bauteil zumindest eine Abschirmung gegen Fremdstrahlung. Bei Fremdstrahlung handelt es sich von außen, das heißt von außerhalb des optoelektronischen Bauteils, um auf das Bauteil auftreffende Strahlung. Zum Beispiel handelt es sich um Sonnenlicht oder um das Licht von Leuchtmitteln wie beispielsweise Scheinwerfern. Die Fremdstrahlung kann, wenn sie nicht abgeschirmt wird, auf den Lumineszenzdiodenchip oder eine andere Komponente des optoelektronischen Bauteils wie beispielsweise eine Linse treffen und dort reflektiert werden. Dadurch wird vom optoelektronischen Bauteil im Betrieb abgestrahlte elektromagnetische Strahlung verfälscht. Die unerwünschte elektromagnetische Strahlung wird dabei auch als Phantomstrahlung bezeichnet.

Die Abschirmung ist nun dazu geeignet, die Fremdstrahlung vom Lumineszenzdiodenchip und/oder anderen Komponenten des optoelektronischen Bauteils abzuhalten. Beispielsweise umgibt die Abschirmung den Lumineszenzdiodenchip nur stellenweise seitlich. Das heißt, die Abschirmung ist lateral benachbart, vorzugsweise lateral beabstandet zum Lumineszenzdiodenchip angeordnet, wobei die Abschirmung den Lumineszenzdiodenchip nicht vollständig seitlich umgibt, sondern die Abschirmung umgibt den Lumineszenzdiodenchip nur an ausgewählten Stellen, beispielsweise entlang einer einzigen Seitenfläche.

Die Abschirmung ist dabei derart angeordnet, dass sie Fremdstrahlung einer äußeren Strahlungsquelle vom Lumineszenzdiodenchip und/oder weiteren optischen Komponenten des optoelektronischen Bauteils abschirmen kann. Ist die Abschirmung beispielsweise als Abschirmung gegen Sonnenlicht vorgesehen, so umgibt die Abschirmung den Lumineszenzdiodenchip vorzugsweise an Seiten des Lumineszenzdiodenchips, welche der Sonne zugewandt sind. Die Abschirmung wirft einen Schatten, in dem sich die abzuschirmenden Komponenten zumindest teilweise oder vollständig befinden.

Gemäß zumindest einer Ausführungsform des optoelektronischen Bauteils ist die Abschirmung einstückig mit zumindest einer Komponente des optoelektronischen Bauteils ausgebildet. Das heißt, die Abschirmung ist mit einer weiteren Komponente des optoelektronischen Bauteils als ein Stück gebildet. Die Abschirmung bildet einen Teil oder einen Bereich der Komponente. "Einstückig" kann dabei insbesondere auch heißen, dass keine Grenzfläche zwischen der Abschirmung und der Komponente angeordnet ist. Die Abschirmung und die Komponente können zum Beispiel gemeinsam hergestellt sein.

Es ist insbesondere auch möglich, dass die Abschirmung mit mehreren Komponenten des optoelektronischen Bauteils einstückig ausgebildet ist. Das optoelektronische Bauteil umfasst in diesem Fall mehrere Abschirmungen, wobei jede Abschirmung einstückig mit einer Komponente des optoelektronischen Bauteils ausgebildet ist. Das heißt, das optoelektronische Bauteil kann eine, zwei oder mehr Abschirmungen umfassen, wobei jede Abschirmung mit einer anderen Komponente des optoelektronischen Bauteils einstückig ausgebildet ist.

Gemäß zumindest einer Ausführungsform des optoelektronischen Bauteils umfasst das Bauteil zumindest einen Lumineszenzdiodenchip, der im Betrieb des optoelektronischen Bauteils elektromagnetische Strahlung emittiert. Ferner umfasst das optoelektronische Bauteil zumindest eine Abschirmung gegen Fremdstrahlung, welche den Lumineszenzdiodenchip nur stellenweise seitlich umgibt. Dabei ist jede der Abschirmungen einstückig mit einer Komponente des optoelektronischen Bauteils ausgebildet. Bei den Komponenten kann es sich beispielsweise um Anschlussträger, Leiterplatten, optische Elemente wie Linsen, Gehäusegrundkörper, und/oder Reflektorwände handeln.

Das hier beschriebene optoelektronische Bauteil beruht dabei unter anderem auf der Erkenntnis, dass eine Abschirmung, die mit einer Komponente des Bauteils einstückig ausgebildet ist, den Montageaufwand des optoelektronischen Bauteils reduziert. So ist es nicht mehr notwendig, optoelektronisches Bauteil und Abschirmung getrennt voneinander zu justieren. Ferner erhöht die einstückige Ausbildung der Abschirmung mit einer Komponente des optoelektronischen Bauteils die mechanische Stabilität des optoelektronischen Bauteils, da eine separat am optoelektronischen Bauteil oder in der Nähe des optoelektronischen Bauteils befestigte Abschirmung beispielsweise aufgrund äußerer Witterungseinflüsse leichter vom optoelektronischen Bauteil getrennt werden kann als eine einstückig mit einer Komponente des Bauteils ausgebildete Abschirmung.

Gemäß zumindest einer Ausführungsform des optoelektronischen Bauteils umfasst das optoelektronische Bauteil einen Anschlussträger. Bei dem Anschlussträger handelt es sich beispielsweise um eine Leiterplatte, welche elektrische Anschlussstellen zum elektrischen Anschließen des zumindest einen Lumineszenzdiodenchip aufweist. Darüber hinaus weist die Leiterplatte Leiterbahnen auf, mittels denen der zumindest eine Lumineszenzdiodenchip elektrisch kontaktiert werden kann. Die Leiterplatte kann dabei zum Beispiel einen elektrisch isolierenden Grundkörper umfassen, in den oder auf den die elektrischen Anschlussstellen und die Leiterbahnen strukturiert sind.

Darüber hinaus ist es möglich, dass es sich bei dem Anschlussträger um einen Trägerrahmen (Leadframe, auch Leiterrahmen) handelt. Auch ein solcher Trägerrahmen dient zur Befestigung und elektrischen Kontaktierung des zumindest einen Lumineszenzdiodenchips.

Der zumindest eine Lumineszenzdiodenchip ist zumindest mittelbar auf dem Anschlussträger befestigt.

Zumindest mittelbar heißt dabei, dass der Lumineszenzdiodenchip direkt auf den Anschlussträger aufgebracht sein kann. Darüber hinaus ist es möglich, dass sich zwischen Lumineszenzdiodenchip und Anschlussträger weitere Komponenten befinden.

Der zumindest eine Lumineszenzdiodenchip ist dabei über den Anschlussträger elektrisch kontaktiert. Das heißt, mittels des Anschlussträgers kann der zumindest eine Lumineszenzdiodenchip im Betrieb des optoelektronischen Bauteils bestromt werden.

Gemäß zumindest einer Ausführungsform des optoelektronischen Bauteils ist die zumindest eine Abschirmung zumindest stellenweise durch einen Abschirmbereich des Anschlussträgers gebildet. Die Abschirmung ist also einstückig mit dem Anschlussträger, und damit mit einer Komponente des optoelektronischen Bauteils ausgebildet.

Das bedeutet, der Anschlussträger weist zumindest zwei Teilbereiche auf: Einen Abschirmbereich, der zumindest eine Abschirmung des optoelektronischen Bauteils gegen Fremdstrahlung bildet. Der Abschirmbereich ist dabei derart angeordnet, dass er den Lumineszenzdiodenchip nur stellenweise seitlich umgibt. Der Abschirmbereich des Anschlussträgers ist dabei zum Beispiel frei von einem Lumineszenzdiodenchip.

Ferner umfasst der Anschlussträger einen restlichen Bereich, auf dem beispielsweise der zumindest eine Lumineszenzdiodenchip angeordnet ist.

Gemäß zumindest einer Ausführungsform des optoelektronischen Bauteils umfasst das Bauteil einen Anschlussträger, auf dem der zumindest eine Lumineszenzdiodenchip zumindest mittelbar befestigt ist und über den der zumindest eine Lumineszenzdiodenchip elektrisch kontaktiert ist. Dabei ist zumindest eine Abschirmung des optoelektronischen Bauteils durch einen Abschirmbereich des Anschlussträgers gebildet.

Gemäß zumindest einer Ausführungsform des optoelektronischen Bauteils weist der Anschlussträger eine Biegung auf. Diese Biegung verbindet den Abschirmbereich des Anschlussträgers mit dem restlichen Anschlussträger, auf dem beispielsweise der zumindest eine Lumineszenzdiodenchip zumindest mittelbar befestigt ist. Der Anschlussträger besteht dabei vorzugsweise aus einem biegbaren Material.

Ferner ist es möglich, dass im Anschlussträger ein Gelenk oder ein Scharnier vorgesehen ist. In jedem Fall weist der Anschlussträger eine Biegung auf, so dass der Abschirmbereich in einem bestimmten Winkel zum Anschlussträger angeordnet ist. Vorzugsweise sind der Abschirmbereich und der restliche Anschlussträger in einem Winkel kleiner gleich 110° zueinander angeordnet.

Das heißt, Abschirmbereich und restlicher Anschlussträger schließen einen Winkel von kleiner gleich 110° miteinander ein. Vorzugsweise ist der Anschlussträger dabei derart biegbar ausgebildet, dass der Benutzer des optoelektronischen Bauteils, beispielsweise nach der Montage des optoelektronischen Bauteils, den Winkel zwischen Abschirmbereich und restlichem Anschlussträger in einem bestimmten Bereich selbst einstellen kann. Auf diese Weise ist es möglich, die Abschirmung optimal an den Einsatzort des optoelektronischen Bauteils anzupassen.

Je nach Montage-Ort des optoelektronischen Bauteils kann über die Einstellung des Winkels eine optimale Abschirmung beispielsweise von Sonnenlicht erfolgen.

Gemäß zumindest einer Ausführungsform des optoelektronischen Bauteils umfasst das Bauteil eine Reflektorwand, welche den zumindest einen Lumineszenzdiodenchip seitlich vollständig umgibt. Die Reflektorwand ist zur Reflexion von vom Lumineszenzdiodenchip im Betrieb erzeugter elektromagnetischer Strahlung geeignet. Vorzugsweise weist die Reflektorwand eine Reflektivität für die vom Lumineszenzdiodenchip im Betrieb erzeugte elektromagnetische Strahlung von wenigstens 90 %, vorzugsweise von wenigstens 95 % auf :

Die Reflektorwand kann dazu aus einem weißen keramischen Material oder mit einem Metall gebildet sein. Die Reflektorwand umgibt den zumindest einen Lumineszenzdiodenchip seitlich vollständig, das heißt sie ist rahmenartig um den Lumineszenzdiodenchip herum angeordnet. Dabei bezieht sich der Begriff "rahmenartig" jedoch nicht auf die Geometrie der Reflektorwand, sondern soll lediglich zum Ausdruck bringen, dass der Lumineszenzdiodenchip seitlich komplett von der Reflektorwand umschlossen ist.

Gemäß zumindest einer Ausführungsform des optoelektronischen Bauteils weist die Reflektorwand eine ungleichmäßige Höhe auf. Das heißt, die Reflektorwand weist Bereiche auf, in denen sie höher ist als in anderen Bereichen. In einem Umlauf um den zumindest einen Leuchtdiodenchip steigt dabei beispielsweise die Höhe der Reflektorwand zunächst an, erreicht eine maximale Höhe, sinkt ab, bis sie eine minimale Höhe erreicht.

Gemäß zumindest einer Ausführungsform des optoelektronischen Bauteils ist zumindest eine Abschirmung des Bauteils gegen Fremdstrahlung zumindest stellenweise durch einen Abschirmbereich der Reflektorwand gebildet. Die Abschirmung ist dabei mittels des Abschirmbereichs einstückig mit der Reflektorwand, also einer Komponente des optoelektronischen Bauteils, ausgebildet.

Der Abschirmbereich der Reflektorwand ist höher ausgebildet als die restliche Reflektorwand. Das heißt, in einem Umlauf um den zumindest einen Lumineszenzdiodenchip weist die Reflektorwand einen Bereich auf, in dem die Höhe ansteigt, ein Maximum erreicht und auf den Anfangswert der Höhe abfällt.

Der Abschirmbereich ist dann durch den Bereich der Reflektorwand gebildet, in welchem die Höhe ansteigt, ein Maximum erreicht und auf den Anfangswert absinkt. Die Bereiche der Reflektorwand, welche höher ausgebildet sind, als die minimale Höhe der Reflektorwand, bilden dann den Abschirmbereich.

Gemäß zumindest einer Ausführungsform des optoelektronischen Bauteils umfasst das Bauteil eine Reflektorwand, welche den zumindest einen Lumineszenzdiodenchip seitlich vollständig umgibt, wobei die Reflektorwand eine ungleichmäßige Höhe aufweist. Dabei ist zumindest eine Abschirmung des optoelektronischen Bauteils gegen Fremdstrahlung zumindest stellenweise durch einen Abschirmbereich der Reflektorwand gebildet, der höher ausgebildet ist als die restliche Reflektorwand.

Gemäß zumindest einer Ausführungsform des optoelektronischen Bauteils ist die Reflektorwand innerhalb einer Linse für den zumindest einen Lumineszenzdiodenchip angeordnet. Die Linse kann die Reflektorwand und den zumindest einen Lumineszenzdiodenchip nach Art einer Kuppel überspannen. Innerhalb der Linse können Reflektorwand und Lumineszenzdiodenchip dann an ein Gas, beispielsweise an Luft, grenzen. Darüber hinaus ist es möglich, dass die Linse als Vollkörper ausgebildet ist, der nach Art eines Vergusses auf den Lumineszenzdiodenchip und die Reflektorwand aufgebracht wird.

Das heißt, Reflektorwand und der zumindest eine Lumineszenzdiodenchip sind in das Material der Linse, also einen Verguss, eingebettet. Dabei ist es auch möglich, dass der Verguss nicht linsenartig ausgeformt ist, sondern ebene Seitenflächen und eine ebene Deckfläche aufweist. In jedem Fall grenzt die Reflektorwand in dieser Ausführungsform zumindest stellenweise direkt an einen Verguss für den zumindest einen Lumineszenzdiodenchip.

Einerseits ist die Reflektorwand und damit die Abschirmung, welche durch einen Abschirmbereich der Reflektorwand gebildet ist, durch den Verguss besonders gut vor äußeren Einflüssen geschützt. Der Abschirmbereich ist damit gegen äußere Witterungseinflüsse sowie gegen mechanische Belastung geschützt.

Andererseits kann sich bei dieser Ausführungsform nachteilig ergeben, dass die Abschirmung keinen Schutz gegen Fremdstrahlung für den gesamten Verguss darstellt. Der Verguss selbst muss in diesem Fall also besonders beständig gegen die Fremdstrahlung, beispielsweise gegen UV-Strahlung, und gegen äußere Einflüsse wie beispielsweise Regenwasser geschützt sein. Dazu kann das optoelektronische Bauteil eine weitere Abschirmung umfassen, die durch den Abschirmbereich eines Anschlussträgers gebildet ist. Ferner können für den Verguss besonders UV-beständige Materialien, wie beispielsweise Silikon, Verwendung finden.

Gemäß zumindest einer Ausführungsform des hier beschriebenen optoelektronischen Bauteils weist das Bauteil anstatt der Reflektorwand eine Absorberwand auf, die auf sie treffende elektromagnetische Strahlung absorbiert. Ansonsten ist die Absorberwand wie die beschriebene Reflektorwand ausgebildet. Die Absorberwand ist zum Beispiel schwarz ausgebildet. Sie kann - zum Beispiel mit einer Farbe - schwarz beschichtet sein, oder aus einem schwarzen Material - wie Ruß gefülltem Kunststoff - gebildet sein.

Die Absorberwand unterdrückt zum Beispiel die Entstehung von Streustrahlung. Die Absorberwand weist dazu eine Reflektivität von vorzugsweise weniger 10 %, besonders bevorzugt von weniger 5% für auf sie treffendes Licht auf.

Gemäß zumindest einer Ausführungsform des hier beschriebenen optoelektronischen Bauteils ist die Reflektorwand oder die Absorberwand einstückig mit einem Träger des Bauteils ausgebildet. Beispielsweise sind die Reflektorwand oder die Absorberwand und der Träger durch ein gemeinsames Spritzgussverfahren oder ein gemeinsames Spritzpressverfahren miteinander hergestellt. Das heißt, die Reflektorwand oder die Absorberwand und der Träger sind gemeinsam spritzgegossen oder spritzgepresst. Es handelt sich dabei um ein gegenständliches Merkmal, das am fertigen Bauteil nachweisbar ist.

Gemäß zumindest einer Ausführungsform des hier beschriebenen optoelektronischen Bauteils umfasst das optoelektronische Bauteil einen Gehäusegrundkörper. Der Gehäusegrundkörper ist beispielsweise aus einem Kunststoffmaterial gefertigt.

Der Gehäusegrundkörper kann eine Kavität aufweisen, in welcher der zumindest eine Lumineszenzdiodenchip angeordnet ist. Der Lumineszenzdiodenchip ist dann in der Kavität seitlich von einer Gehäusewand des Gehäusegrundkörpers umgeben, welche als Reflektorwand ausgebildet sein kann. Diese Reflektorwand weist eine gleichmäßige Höhe auf. Es ist jedoch auch möglich, dass die Reflektorwand wie weiter oben beschrieben eine ungleichmäßige Höhe aufweist und dadurch eine der Abschirmung des optoelektronischen Bauteils gegen Fremdstrahlung bildet.

Gemäß zumindest einer Ausführungsform des optoelektronischen Bauteils ist zumindest eine Abschirmung des Bauteils zumindest stellenweise durch einen Abschirmbereich des Gehäusegrundkörpers gebildet. Das heißt, einstückig mit dem Gehäusegrundkörper und damit einstückig mit einer Komponente des optoelektronischen Bauteils ist ein Abschirmbereich des Gehäusegrundkörpers gebildet, in welchem der Gehäusegrundkörper beispielsweise nach Art eines Vorsprungs ausgebildet ist. Dieser Vorsprung umgibt den Lumineszenzdiodenchip seitlich nur stellenweise.

Gemäß zumindest einer Ausführungsform des optoelektronischen Bauteils umfasst das Bauteil einen Gehäusegrundkörper, der eine Kavität aufweist, in welcher der zumindest eine Lumineszenzdiodenchip angeordnet ist. Dabei ist zumindest eine Abschirmung des optoelektronischen Bauteils gegen Fremdstrahlung zumindest stellenweise durch einen Abschirmbereich des Gehäusegrundkörpers gebildet.

Der Abschirmbereich des Gehäusegrundkörpers kann innerhalb oder außerhalb einer Linse und/oder eines Vergusses für den zumindest einen Lumineszenzdiodenchip angeordnet sein. In jedem Fall ist der Abschirmbereich gemeinsam mit dem Gehäusegrundkörper besonders einfach beispielsweise mittels Spritzpressen oder Spritzgießen herstellbar. Das heißt, gemäß zumindest einer Ausführungsform des hier beschriebenen optoelektronischen Bauteils ist der Abschirmbereich zusammen mit dem restlichen Gehäusegrundkörper spritzgegossen oder spritzgepresst ausgeführt. Bei "spritzgegossen" oder "spritzgepresst" handelt es sich dabei um gegenständliche Merkmale, welche am fertigen Produkt nachweisbar sind. Das heißt, am fertigen Produkt ist nachweisbar, dass der Abschirmbereich mit dem Gehäusegrundkörper einstückig durch Spritzgießen oder Spritzpressen ausgeführt wurde.

Der Gehäusegrundkörper kann beispielsweise stellenweise um einen Anschlussträger gegossen oder gespritzt werden, auf dem der zumindest eine Lumineszenzdiodenchip zumindest mittelbar befestigt ist.

Gemäß zumindest einer Ausführungsform des hier beschriebenen optoelektronischen Bauteils umfasst das optoelektronische Bauteil eine Linse für den zumindest einen Lumineszenzdiodenchip. Bei der Linse handelt es sich um ein optisches Element, welches beispielsweise die Wahrscheinlichkeit für Auskopplung von elektromagnetischer Strahlung aus dem optoelektronischen Bauteil erhöht. Darüber hinaus kann die Linse strahlformende Eigenschaften aufweisen. Die Linse kann beispielsweise für die durchtretende elektromagnetische Strahlung fokussierend oder streuend wirken.

Gemäß zumindest einer Ausführungsform des optoelektronischen Bauteils ist zumindest eine Abschirmung des optoelektronischen Bauteils gegen Fremdstrahlung zumindest stellenweise durch einen Abschirmbereich der Linse gebildet. Das heißt, die Linse umfasst an bestimmten Stellen einen Abschirmbereich, der durch eine Strukturierung, eine Beschichtung oder eine teilweise Färbung der Linse gebildet ist. Beispielsweise kann die Linse im Abschirmbereich polarisierend, absorbierend und/oder reflektierend ausgebildet sein. Dies kann beispielsweise durch eine teilweise Beschichtung der dem zumindest einen Lumineszenzdiodenchip abgewandten Außenfläche der Linse mit einem Metall realisiert sein.

Gemäß zumindest einer Ausführungsform des optoelektronischen Bauteils umfasst das Bauteil eine Linse für den zumindest einen Lumineszenzdiodenchip, wobei zumindest eine Abschirmung des optoelektronischen Bauteils durch einen Abschirmbereich der Linse gebildet ist.

Gemäß zumindest einer Ausführungsform des optoelektronischen Bauteils weist zumindest eine der Abschirmungen des optoelektronischen Bauteils zumindest einen Reflexionsbereich auf, der dem zumindest einen Lumineszenzdiodenchip zugewandt ist und für vom Lumineszenzdiodenchip im Betrieb des optoelektronischen Bauteils erzeugte elektromagnetische Strahlung reflektierend ausgebildet ist.

Das heißt, vom Lumineszenzdiodenchip erzeugte Strahlung kann teilweise im Betrieb des optoelektronischen Bauteils auf den Reflexionsbereich der Abschirmung treffen und wird dort reflektiert. Der Reflexionsgrad beträgt dabei vorzugsweise wenigstens 90 %, besonders bevorzugt wenigstens 95 %.

Die restlichen Bereiche der Abschirmung, insbesondere jene Bereiche, auf welche die Fremdstrahlung trifft, sind vorzugsweise strahlungsabsorbierend ausgestaltet. Das heißt, sie absorbieren die einfallende Fremdstrahlung, so dass an der Abschirmung kein Streulicht entsteht, welches den optischen Eindruck des optoelektronischen Bauteils stören könnte. In jedem Fall ist die Abschirmung strahlungsundurchlässig für die Fremdstrahlung ausgebildet, so dass keine Fremdstrahlung durch die Abschirmung hindurch auf abzuschirmende Bereiche des optoelektronischen Bauteils treffen kann.

Gemäß zumindest einer Ausführungsform des optoelektronischen Bauteils ist die Abschirmung zumindest in einem Absorptionsbereich, der dem zumindest einen Lumineszenzdiodenchip zugewandt ist, für vom Lumineszenzdiodenchip im Betrieb des optoelektronischen Bauteils erzeugte elektromagnetische Strahlung absorbierend ausgebildet. Das heißt, in diesen Absorptionsbereichen erfolgt keine Reflexion oder kaum Reflexion der auftreffenden elektromagnetischen Strahlung des Lumineszenzdiodenchips, sondern diese Strahlung wird im Absorptionsbereich absorbiert. Der Absorptionsgrad beträgt dabei vorzugsweise wenigstens 90, besonders bevorzugt wenigstens 95 %.

Die Abschirmung kann im Gesamten dem zumindest einen Lumineszenzdiodenchip zugewandten Bereich reflektierend oder absorbierend ausgebildet sein. Darüber hinaus ist es möglich, dass die Abschirmung dort reflektierend ausgebildete Reflexionsbereiche und absorbierend ausgebildete Absorptionsbereiche aufweist.

Gemäß zumindest einer Ausführungsform des optoelektronischen Bauteils weist zumindest eine der Abschirmungen eine Krümmung auf. "Krümmung" bedeutet dabei, dass die Abschirmung nach Art eines Bogens, eines Kugelsegments, eines Kugelschalensegments, eines Hohlzylindersegments oder ähnlicher geometrischer Figuren stellenweise seitlich um den zumindest einen Lumineszenzdiodenchip herumgeführt ist. Eine derartige Ausbildung der Abschirmung kann sich in zweifacher Weise als vorteilhaft erweisen.

Zum einen kann eine solche Abschirmung, wenn sie in ihrem dem Lumineszenzdiodenchip zugewandten Bereich absorbierend und/oder reflektierend ausgebildet ist, optische Aufgaben im optoelektronischen Bauteil wahrnehmen. Das heißt, die Abschirmung mit Krümmung kann zur Einstellung einer definierten Abstrahlcharakteristik des optoelektronischen Bauteils beitragen.

Zum anderen kann die Krümmung geeignet sein, Feuchtigkeit insbesondere Regenwasser, das von außen auf das optoelektronische Bauteil auftrifft, um die Strahlungsaustrittsfläche des optoelektronischen Bauteils herumzuführen.

Die Strahlungsaustrittsfläche des optoelektronischen Bauteils ist dabei jene gegebenenfalls gedachte Fläche des Bauteils, durch welche die im Betrieb erzeugte elektromagnetische Strahlung nach außen tritt. Die Strahlungsaustrittsfläche kann beispielsweise durch den Teil der Außenfläche einer Linse oder eines Vergusses gebildet sein. Die Krümmung der Abschirmung kann geeignet sein, Regenwasser um die Strahlungsaustrittsfläche herumzuführen, insbesondere wenn die Abschirmung außerhalb einer Linse oder eines Vergusses oder einstückig mit einer Linse oder einem Verguss ausgebildet ist.

Das hier beschriebene optoelektronische Bauteil kann genau eine der beschriebenen Abschirmungen aufweisen. Darüber hinaus ist es möglich, dass das hier beschriebene optoelektronische Bauteil eine Kombination von zwei oder mehr der hier beschriebenen Abschirmungen aufweist.

So kann das optoelektronische Bauteil beispielsweise eine Abschirmung aufweisen, die durch einen Abschirmbereich eines Anschlussträgers gebildet ist. Zusätzlich kann das optoelektronische Bauteil dann eine Abschirmung aufweisen, die durch den Abschirmbereich einer Reflektorwand gebildet ist. Ferner kann eine Linse für den zumindest einen Lumineszenzdiodenchip des optoelektronischen Bauteils einen Abschirmbereich aufweisen. Durch die Kombination von zwei oder mehr Abschirmungen ist es möglich, ein besonders gut gegen Fremdstrahlung geschütztes optoelektronisches Bauteil anzugeben.

Das hier beschriebene optoelektronische Bauteil eignet sich beispielsweise besonders gut zur Bildung eines Großbilddisplays, bei dem einzelne Pixel durch ein hier beschriebenes optoelektronisches Bauteil gebildet sind. Das heißt, das Display ist durch eine Vielzahl matrixartig angeordneter optoelektronischer Bauteile gebildet. Jedes der Bauteile weist dabei zumindest eine Abschirmung auf, die es vor Fremdlichteinstrahlung, beispielsweise vor Sonnenlicht, schützt. Darüber hinaus kann die Abschirmung eines jeden optoelektronischen Bauteils einen Schutz der Strahlungsaustrittsfläche des Bauteils vor Regenwasser bilden. Auf diese Weise kann das Display auch unter schlechten Witterungsbedingungen betrieben werden. Durch das Ableiten von Regenwasser durch eine Abschirmung des optoelektronischen Bauteils kommt es nicht zur Ablagerung von Wasser auf der Strahlungsaustrittsfläche des Bauteils, so dass Streulicht aufgrund von Wassertropfen, welche wie unerwünschte optische Elemente wirken, unterbunden wird.

Im Folgenden wird das hier beschriebene optoelektronische Bauteil anhand von Ausführungsbeispielen und den zugehörigen Figuren näher erläutert.

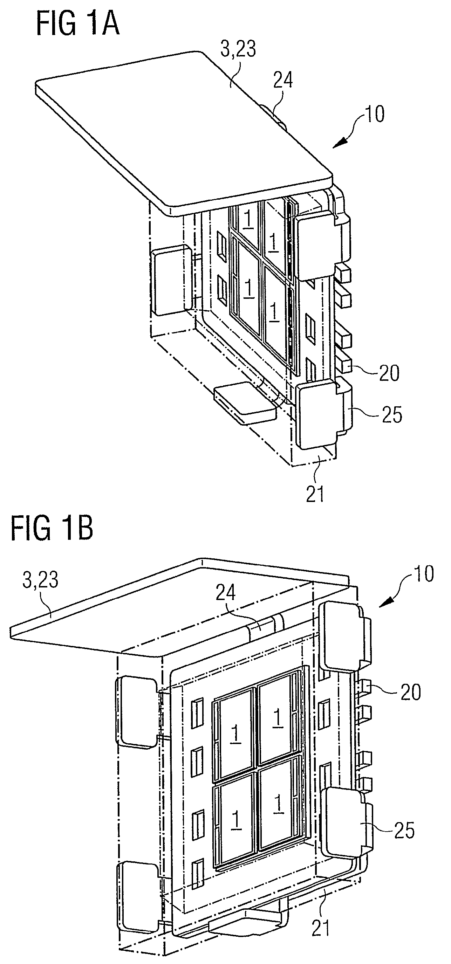

Die Figuren 1A bis 5B zeigen dabei Beispiele und Ausführungsbeispiele von hier beschriebenen optoelektronischen Bauteilen in schematischen Perspektivdarstellungen.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

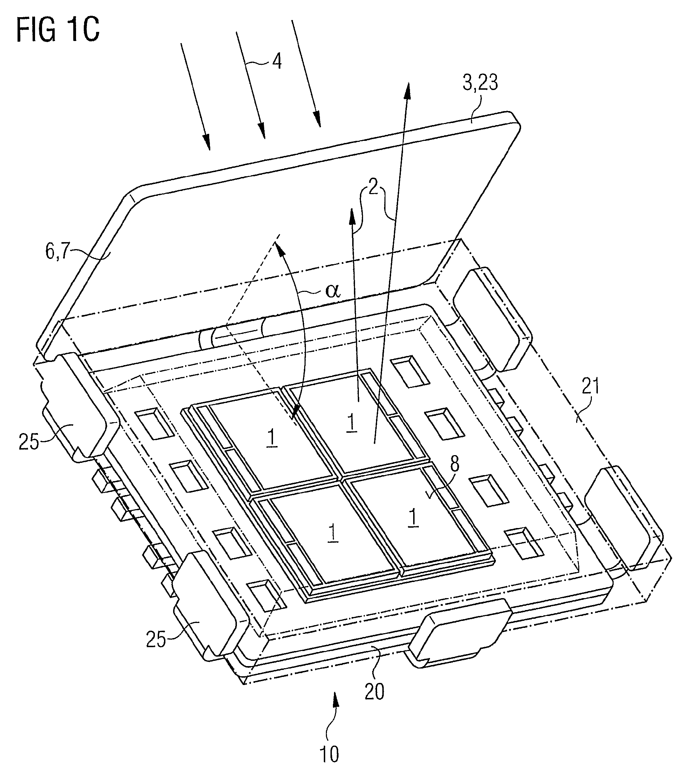

Die Figuren 1A, 1B und 1C zeigen ein erstes Beispiel eines hier beschriebenen optoelektronischen Bauteils anhand schematischer Perspektivdarstellungen. Das optoelektronische Bauteil 10 weist vier Lumineszenzdiodenchips 1 auf, die als Leuchtdiodenchips ausgebildet sind. Die vier Lumineszenzdiodenchips 1 können dabei Licht der gleichen Farbe oder unterschiedlicher Farben emittieren. Beispielsweise ist ein Lumineszenzdiodenchip 1 zur Erzeugung von blauem Licht, ein Lumineszenzdiodenchip 1 zur Erzeugung von rotem Licht und sind zwei Lumineszenzdiodenchips 1 zum Erzeugen von grünem Licht vorgesehen.

Die Lumineszenzdiodenchips 1 sind auf einem Anschlussträger 20 befestigt, der vorliegend als metallischer Trägerrahmen ausgeführt ist. Die Lumineszenzdiodenchips 1 sind von einem Verguss 21 umgeben.

Die den Lumineszenzdiodenchips 1 abgewandte Außenfläche des Vergusses 21 bildet die Strahlungsaustrittsfläche 8 des optoelektronischen Bauteils 10.

Der Anschlussträger 20 weist Laschen 25 auf, in denen er zum Verguss 21 hin hochgebogen ist. Dies erhöht die Haftung des Vergusses 21 an den verbleibenden Komponenten des optoelektronischen Bauteils 10 wie dem Anschlussträger 20 oder den Lumineszenzdiodenchips 1.

Alternativ zu einem Verguss 21 können die Lumineszenzdiodenchips 1 auch von einer Glasplatte abgedeckt sein. Die Glasplatte weist dann vorzugsweise auf ihrer den Lumineszenzdiodenchips 1 zugewandten Seite im Bereich der Lumineszenzdiodenchips 1 zumindest eine Ausnehmung auf, in der sie in ihrer Dicke reduziert ist. In dieser Ausnehmung sind die Lumineszenzdiodenchips 1 angeordnet. Die Ausnehmung kann zum Beispiel durch ein Ätzen der Glasplatte erzeugt werden.

Der Anschlussträger 20 weist ferner einen Abschirmbereich 23 auf, mit welchem der Anschlussträger 20 einstückig ausgebildet ist. Der Abschirmbereich 23 ist im Prinzip eine vergrößerte Lasche 25, welche sich entlang einer Seitenfläche des optoelektronischen Bauteils 10 erstreckt. Der Abschirmbereich 23 überragt den Verguss 21 wenigstens um die Höhe des Vergusses 21. Der Abschirmbereich 23 umgibt die Lumineszenzdiodenchips 1 nur stellenweise seitlich. Das heißt, der Abschirmbereich 23 ist lateral benachbart zu einer Seitenfläche des Lumineszenzdiodenchips 1 angeordnet. Der Abschirmbereich 23 umgibt die Lumineszenzdiodenchips 1 nicht vollständig seitlich.

Im vorliegenden Beispiel bildet der Abschirmbereich 23 die einzige Abschirmung 3 des optoelektronischen Bauteils gegen Fremdstrahlung 4, welche von außerhalb auf das Bauteil 10 einfällt. Der Abschirmbereich 23 ist mittels einer Biegung 24 mit dem restlichen Anschlussträger 20 verbunden. Im Bereich der Biegung 24 ist der Anschlussträger 20 derart verbogen, dass der Abschirmbereich 23 einen Winkel α von zirka 90° mit dem restlichen Anschlussträger 20 einschließt.

Die den Lumineszenzdiodenchip 1 zugewandte Innenfläche des Abschirmbereichs 23 kann als Reflexionsbereich 6 und/oder als Absorptionsbereich 7 ausgeführt sein. Das heißt, je nach Bedarf, ist diese Fläche für von den Lumineszenzdiodenchips 1 im Betrieb erzeugte elektromagnetische Strahlung 2 absorbierend oder reflektierend ausgebildet.

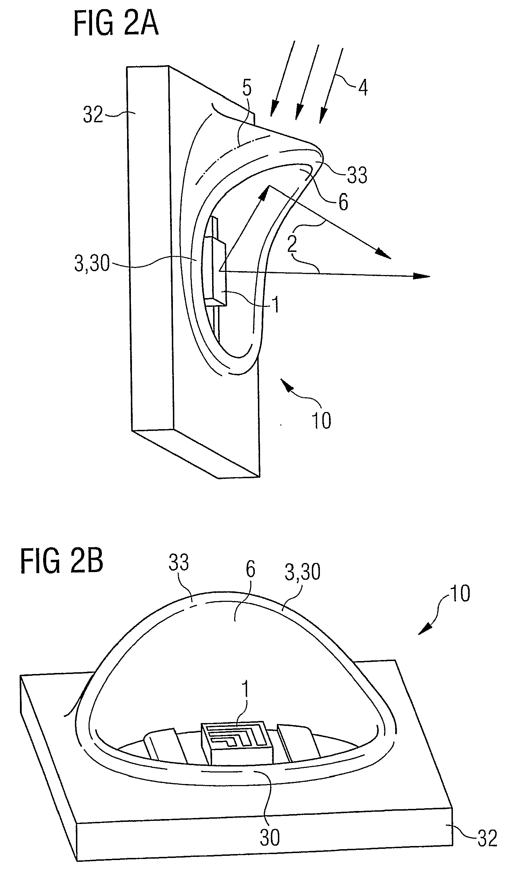

Vorzugsweise ist beim Beispiel, das in Verbindung mit den Figuren 1A, 1B und 1C beschrieben ist, der Anschlussträger 20 derart biegbar ausgebildet, dass vom Verwender des optoelektronischen Bauteils der Winkel α durch einfaches mechanisches Verbiegen in einem gewissen Rahmen je nach Einsatz des optoelektronischen Bauteils eingestellt werden kann. Damit kann auf einfache Weise eine Anpassung des optoelektronischen Bauteils an seinen Einsatzort erfolgen. In Verbindung mit den Figuren 2A und 2B ist ein weiteres Beispiel eines hier beschriebenen optoelektronischen Bauteils 10 näher erläutert. Die Figuren 2A und 2B zeigen dabei schematische Perspektivdarstellungen des optoelektronischen Bauteils 10. In diesem Ausführungsbeispiel weist das Bauteil 10 eine Reflektorwand 30 auf. Die Reflektorwand 30 weist eine ungleichmäßige Höhe auf. In ihrem höchsten Bereich - der Abschirmbereich 33 der Reflektorwand - bildet die Reflektorwand 30 die Abschirmung 3. Das heißt, in diesem Bereich schirmt die Reflektorwand Fremdstrahlung 4 von den optischen Komponenten des optoelektronischen Bauteils ab.

Die Reflektorwand 30 ist im Abschirmbereich 33 an ihrer dem Lumineszenzdiodenchip 1 zugewandten Seite als Reflexionsbereich 6 ausgebildet, der vom Lumineszenzdiodenchip 1 im Betrieb erzeugte Strahlung 2 reflektiert.

Die Reflektorwand 30 kann als separate Komponente des Bauteils auf den Träger 32 aufgebracht sein. Erfindungsgemäss sind Reflektorwand 30 und Träger 32 einstückig miteinander ausgebildet und beispielsweise durch einen gemeinsamen Spritzguss oder ein gemeinsames Spritzpressverfahren miteinander hergestellt sind. Bei dem Träger 32 kann es sich zum Beispiel um den elektrisch isolierend ausgebildeten Grundkörper der Leiterplatte handeln, über die der Lumineszenzdiodenchip 1 elektrisch kontaktiert ist.

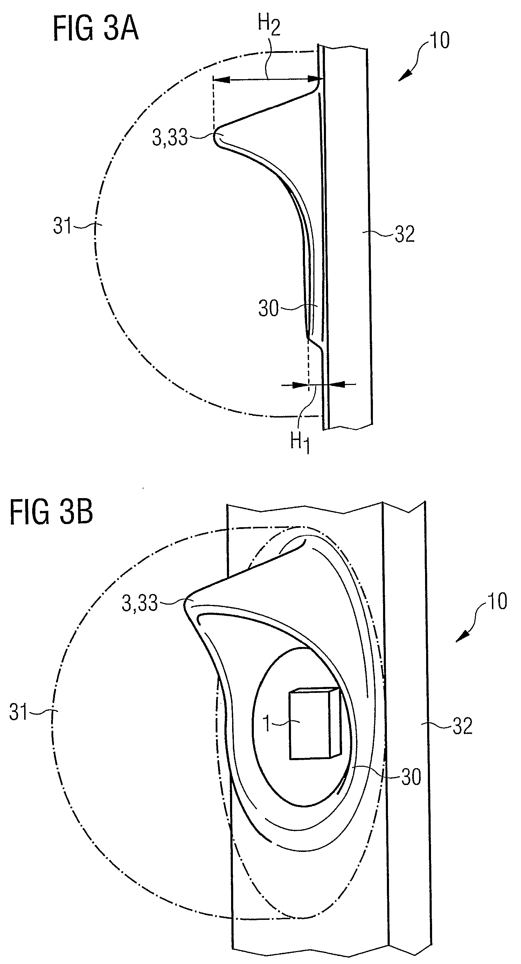

Der Abschirmbereich 33 ist einstückig mit der Reflektorwand 30 ausgebildet und zeichnet sich dadurch aus, dass er eine größere Höhe H2 als die minimale Höhe H1 der Reflektorwand 30 aufweist (siehe dazu auch die Figur 3A). Die Abschirmung 3, das heißt der Abschirmbereich 33 der Reflektorwand, weist eine Krümmung 5 auf, die beispielsweise Regenwasser, welches aus derselben Richtung wie das Fremdlicht 4 einfallen kann, um die optischen Komponenten des optoelektronischen Bauteils 10 herum nach außen abführt.

Anstatt der Reflektorwand 30 kann das optoelektronische Bauteil 10 aber auch eine Absorberwand 30 aufweisen, die auf sie treffende elektromagnetische Strahlung absorbiert. Die Absorberwand ist zum Beispiel schwarz ausgebildet. Sie kann - zum Beispiel mit einer Farbe - schwarz beschichtet sein, oder aus einem schwarzen Material - wie Ruß gefülltem Kunststoff - gebildet sein. Die Absorberwand unterdrückt zum Beispiel die Entstehung von Streustrahlung. Die Absorberwand weist dazu eine Reflektivität von vorzugsweise weniger 10 %, besonders bevorzugt von weniger 5% für auf sie treffendes Licht auf.

In Verbindung mit den Figuren 3A und 3B ist ein Ausführungsbeispiel eines hier beschriebenen optoelektronischen Bauteils näher erläutert. In Ergänzung zum optoelektronischen Bauteil, wie es in Verbindung mit den Figuren 2A und 2B erläutert ist, weist das optoelektronische Bauteil 10 hier eine Linse 31 auf, welche sowohl den Lumineszenzdiodenchip 1 als auch die Reflektorwand 30 mit Abschirmbereich 33 umgibt. Die Linse 31 überspannt dabei die Komponenten des Bauteils 10 kuppel- oder domartig. Die Linse 31 kann als Hohlkörper ausgebildet sein, so dass sie nach Art einer Käseglocke über Reflektorwand 30 und Lumineszenzdiodenchip 1 gestülpt ist. Darüber hinaus ist es möglich, dass die Linse 31 als Vollkörper ausgebildet ist. Die Linse 31 kann als Art Verguss über Lumineszenzdiodenchip 1 und Reflektorwand 30 aufgebracht sein, so dass die Reflektorwand 30 und damit der Abschirmbereich 33 im Verguss der Linse 31 eingebettet sind.

In Verbindung mit der Figur 3A ist nochmals dargestellt, dass die Reflektorwand 30 eine minimale Höhe H1 aufweist, in der sie keinen Abschirmbereich 33 bildet. Nur im Bereich, wo die Reflektorwand 30 eine Höhe größer H1 aufweist, mit der maximalen Höhe H2, bildet sie den Abschirmbereich 33. Das heißt, die durch den Abschirmbereich 33 gebildete Abschirmung umgibt den Lumineszenzdiodenchip 1 nur stellenweise seitlich. Dadurch, dass die Reflektorwand 30 Bereiche mit reduzierter Höhe H1 aufweist ist die Abschirmung 3, das heißt der Abschirmbereich 33, nicht vollständig um den Lumineszenzdiodenchip 1 herumgeführt. Die Reflektorwand 30 ist also unsymmetrisch ausgebildet.

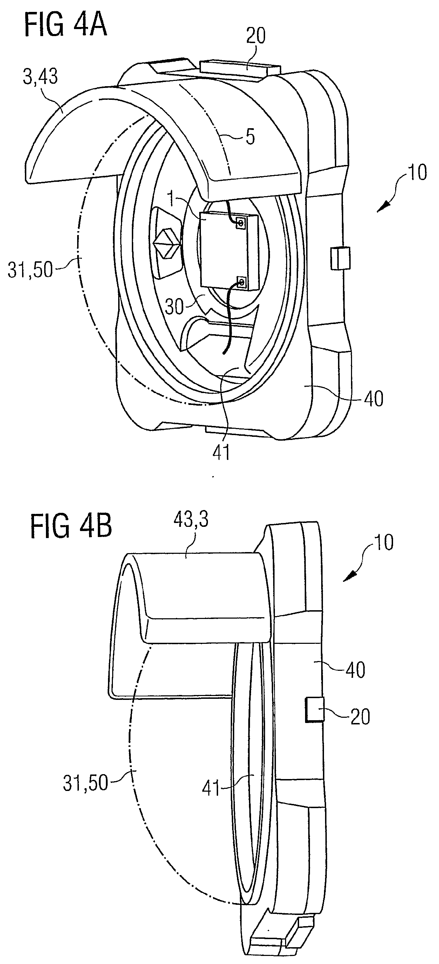

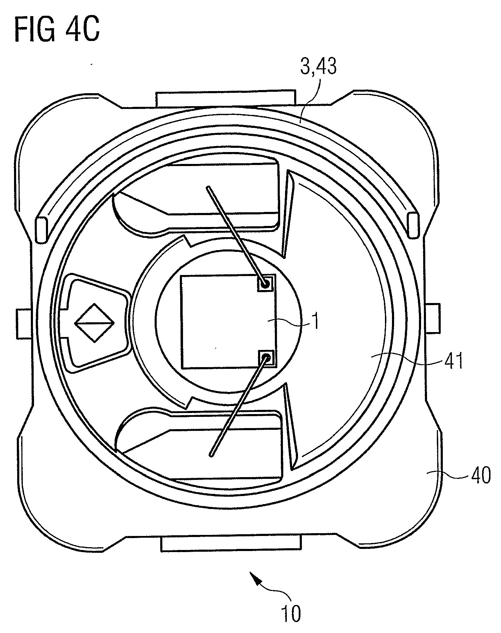

In Verbindung mit den Figuren 4A, 4B und 4C ist ein weiteres Beispiel eines hier beschriebenen optoelektronischen Bauteils 10 näher erläutert. Im Unterschied zum in Verbindung mit den Figuren 3A und 3B beschriebenen Ausführungsbeispiel ist der Abschirmbereich 3 hier außerhalb der Linse 31, 50 angeordnet. Das optoelektronische Bauteil 10 umfasst in diesem Ausführungsbeispiel einen Gehäusegrundkörper 40, welcher einen Anschlussträger 20 umgibt. Beispielsweise ist der Gehäusegrundkörper 40 auf den Anschlussträger, der als Trägerstreifen ausgebildet sein kann, aufgespritzt.

Das heißt der Anschlussträger 20 ist mit dem Material des Grundkörpers 40 umspritzt. Der Grundkörper 40 weist eine Kavität 41 auf, in welcher der Lumineszenzdiodenchip 1 angeordnet ist. Um den Lumineszenzdiodenchip 1 herum ist eine Reflektorwand 30 angeordnet, die in diesem Fall eine gleichmäßige Höhe aufweist, und keinen Abschirmbereich 33 umfasst. Vielmehr weist der Gehäusegrundkörper 40 einen Abschlussbereich 43 auf, mit dem er einstückig ausgebildet ist. Der Anschlussbereich 43 ist nach Art eines Vorsprungs ausgebildet und beispielsweise zusammen mit dem Gehäusegrundkörper spritzgepresst oder spritzgegossen. Alternativ ist es möglich, dass der Abschirmbereich 43 mittels einer Presspassung im Gehäusegrundkörper 40 befestigt ist. Das heißt, der Abschirmbereich 43 ist in diesem Fall in den Gehäusegrundkörper 40 eingesteckt, an diesen angeklebt oder auf andere Art befestigt. In jedem Fall umgibt der Abschirmbereich 43 und damit die Abschirmung 3 den Lumineszenzdiodenchip 1 seitlich nur stellenweise. Der Abschirmbereich ist dabei derart hoch ausgebildet, dass er wenigstens so hoch wie der höchste Punkt der Linse 31, 50 ist, oder die Linse 31, 50 überragt. Der Abschirmbereich 43 weist eine Krümmung 5 auf, welche zum Herumführen von Regenwasser um die Linse 31, 50 und damit um die Strahlungsaustrittsfläche 8 des optoelektronischen Bauteils vorgesehen ist.

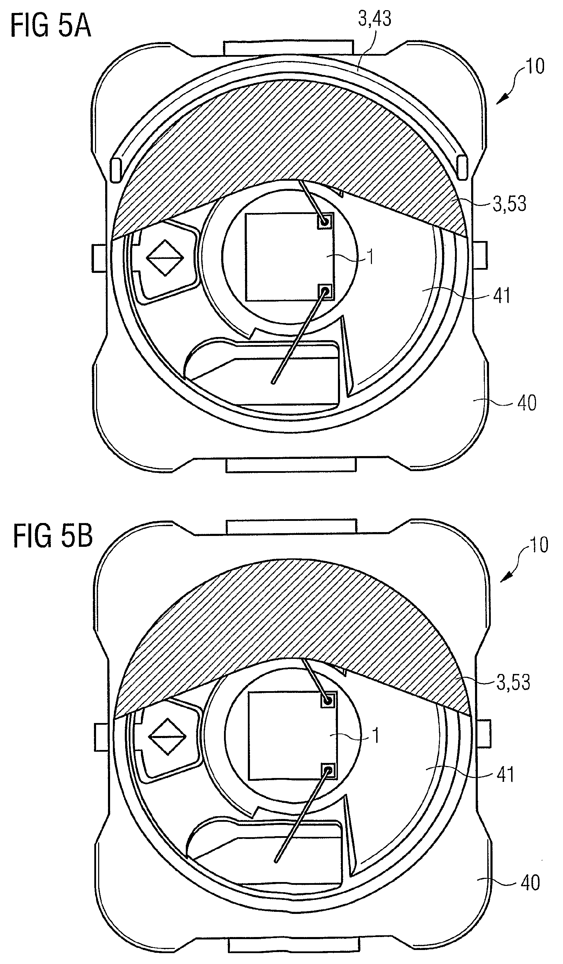

In Verbindung mit der Figur 5A ist anhand einer perspektivischen schematischen Draufsicht ein weiteres Beispiel eines hier beschriebenen optoelektronischen Bauteils näher erläutert. In diesem Beispiel weist das Bauteil zwei verschiedene Abschirmungen 3 auf. Zum einen weist das Bauteil eine Abschirmung 3 auf, die durch einen Abschirmbereich 43 des Grundkörpers 40 gebildet ist, wie beispielsweise in Verbindung mit den Figuren 4A bis 4C beschrieben. Darüber hinaus weist das Bauteil 10 eine Abschirmung 3 auf, die durch einen Abschirmbereich 53 der Linse 50 gebildet ist. Im Abschirmbereich 53 ist die Linse an ihrer Außenfläche mit einem Material beschichtet und dadurch absorbierend ausgebildet. Das heißt, vom Lumineszenzdiodenchip 1 im Betrieb erzeugte elektromagnetische Strahlung 2 wird von diesem Bereich der Linse absorbiert.

Ebenso wird von außen auf die Linse auftreffende Strahlung 4, welche durch den Abschirmbereich 43 des Grundkörpers 40 nicht abgehalten wird, auch absorbiert. Darüber hinaus ist es möglich, dass der Abschirmbereich 53 der Linse polarisierend oder reflektierend ausgebildet ist. Das Beispiel, das in Verbindung mit der Figur 5A beschrieben ist, ist darüber hinaus ein exemplarisches Beispiel dafür, dass die hier beschriebenen Abschirmungen für das optoelektronische Bauteil in ein und demselben optoelektronischen Bauteil 10 miteinander kombiniert werden können. Auf diese Weise können die Vorteile der einzelnen Abschirmungen kombiniert werden, wodurch sich besonders vorteilhafte optoelektronische Bauteile 10 ergeben.

Schließlich ist in Verbindung mit der Figur 5B ein weiteres Beispiel eines hier beschriebenen optoelektronischen Bauteils erläutert. Im Unterschied zum Bauteil, das in Verbindung mit der Figur 5A beschrieben ist, zeigt die Figur 5B ein Bauteil, bei dem die Abschirmung 3 lediglich durch einen Abschirmbereich 53 der Linse 50 gebildet ist.

## Patentansprüche

1. Optoelektronisches Bauteil (10) mit
- zumindest einem Lumineszenzdiodenchip (1), der im Betrieb des optoelektronischen Bauteils elektromagnetische Strahlung (2) emittiert,
- zumindest einer Abschirmung (3) gegen Fremdstrahlung (4), welche den Lumineszenzdiodenchip (1) nur stellenweise seitlich umgibt,
- einer Reflektorwand oder Absorberwand (30), welche den zumindest einen Lumineszenzdiodenchip (1) seitlich vollständig umgibt, und
- einem Anschlussträger (20), auf dem der zumindest eine Lümineszenzdiodenchip (1) zumindest mittelbar befestigt ist und über den der zumindest eine Lumineszenzdiodenchip (1) elektrisch kontaktiert ist,
wobei
- jede Abschirmung (3) einstückig mit einer Komponente (20, 30, 40, 50) des optoelektronischen Bauteils (10) ausgebildet ist,
- die Reflektorwand oder Absorberwand (30) eine ungleichmäßige Höhe (H) aufweist,
- die zumindest eine Abschirmung (3) zumindest stellenweise durch einen Abschirmbereich (33) der Reflektorwand oder Absorberwand (30) gebildet ist, der höher ausgebildet ist, als die restliche Reflektorwand oder Absorberwand (30)
- die Reflektorwand oder Absorberwand (30) innerhalb einer Linse (31, 50) für den zumindest einen Lumineszenzdiodenchip (1) angeordnet ist,
- der Anschlussträger (20) eine Leiterplatte ist, wobei die Leiterplatte einen elektrisch isolierenden Grundkörper (32) umfasst, in den oder auf den elektrische Anschlussstellen und Leiterbahnen strukturiert sind, und
- die Reflektorwand oder Absorberwand (30) mit dem elektrisch isolierend ausgebildeten Grundkörper (32) einstückig ausgebildet ist.

2. Optoelektronisches Bauteil gemäß dem vorherigen Anspruch,
bei dem
- die zumindest eine Abschirmung (3) zumindest stellenweise durch einen Abschirmbereich (23) des Anschlussträgers (20) gebildet ist.

3. Optoelektronisches Bauteil gemäß dem vorherigen Anspruch,
bei dem der Anschlussträger (20) eine Biegung (24) aufweist, welche den Abschirmbereich (23) des Anschlussträgers (20) mit dem restlichen Anschlussträger (20) verbindet.

4. Optoelektronisches Bauteil gemäß Anspruch 2 oder 3,
bei dem der Abschirmbereich (23) und der restliche Anschlussträger (20) einen Winkel (α) von kleiner gleich 110° miteinander einschließen.

5. Optoelektronisches Bauteil gemäß Anspruch 1,
bei dem die Reflektorwand oder Absorberwand (30) in einem Verguss (21) für den zumindest einen Lumineszenzdiodenchip (1) eingebettet ist.

6. Optoelektronisches Bauteil gemäß einem der vorherigen Ansprüche mit
- einem Gehäusegrundkörper (40), der eine Kavität (41) aufweist, in welcher der zumindest eine Lumineszenzdiodenchip (1) angeordnet ist, wobei
- die zumindest eine Abschirmung (3) zumindest stellenweise durch einen Abschirmbereich (43) des Gehäusegrundkörpers (40) gebildet ist.

7. Optoelektronisches Bauteil gemäß dem vorherigen Anspruch,
bei dem der Abschirmbereich (43) zusammen mit dem restlichen Gehäusegrundkörper (40) spritzgegossen oder spritzgepresst ist.

8. Optoelektronisches Bauteil gemäß einem der vorherigen Ansprüche mit
- einer Linse (31,50) für den zumindest einen Lumineszenzdiodenchip (1), wobei
- die zumindest eine Abschirmung (3) zumindest stellenweise durch einen Abschirmbereich (53) der Linse (31,50) gebildet ist.

9. Optoelektronisches Bauteil gemäß dem vorherigen Anspruch,
bei dem die Linse (31,50) im Abschirmbereich (53) polarisierend, absorbierend und/oder reflektierend ausgebildet ist.

10. Optoelektronisches Bauteil gemäß einem der vorherigen Ansprüche,
bei dem die Abschirmung (3) zumindest in einem Reflexionsbereich (6), der dem zumindest einem Lumineszenzdiodenchip (1) zugewandt ist, für vom Lumineszenzdiodenchip (1) im Betrieb des optoelektronischen Bauteils erzeugte elektromagnetische Strahlung (2) reflektierend ausgebildet ist.

11. Optoelektronisches Bauteil gemäß einem der vorherigen Ansprüche,
bei dem die zumindest eine Abschirmung (3) zumindest in einem Absorptionsbereich (7), der dem zumindest einem Lumineszenzdiodenchip (1) zugewandt ist, für vom Lumineszenzdiodenchip im Betrieb des optoelektronischen Bauteils erzeugte elektromagnetische Strahlung (2) absorbierend ausgebildet ist.

12. Optoelektronisches Bauteil gemäß einem der vorherigen Ansprüche,
bei dem die zumindest eine Abschirmung (3) eine Krümmung (5) aufweist.

13. Optoelektronisches Bauteil gemäß dem vorherigen Anspruch,
bei dem die Abschirmung (3) zur Umleitung von Regenwasser um eine Strahlungsaustrittsfläche (8) des optoelektronischen Bauteils herum vorgesehen ist.

## Claims

1. Optoelectronic device (10) comprising
- at least one luminescence diode chip (1) which emits electromagnetic radiation (2) during the operation of the optoelectronic device,
- at least one shield (3) against stray radiation (4) which laterally surrounds the luminescence diode chip (1) only in places,
- a reflector wall or absorber wall (30), which laterally completely surrounds the at least one luminescence diode chip (1), and
- a connection carrier (20), on which the at least one luminescence diode chip (1) is fixed at least indirectly and via which electrical contact is made with the at least one luminescence diode chip (1),
wherein
- each shield (3) is embodied integrally with a component (20, 30, 40, 50) of the optoelectronic device (10),
- the reflector wall or absorber wall (30) has a non-uniform height (H),
- the at least one shield (3) is formed, at least in places, by a shielding region (33) of the reflector wall or absorber wall (30), said shielding region being embodied in a manner higher than the rest of the reflector wall or absorber wall (30)
- the reflector wall or absorber wall (30) is arranged within a lens (31, 50) for the at least one luminescence diode chip (1),
- the connection carrier (20) is a printed circuit board, wherein the printed circuit board comprises an electrically insulating base body (32), into which or onto which are structured electrical connection locations and conductor tracks, and
- the reflector wall or absorber wall (30) is embodied integrally with the electrically insulating base body (32).

2. Optoelectronic device according to the preceding claim,
wherein the at least one shield (3) is formed by a shielding region (23) of the connection carrier (20) at least in places.

3. Optoelectronic device according to the preceding claim,
wherein the connection carrier (20) has a bend (24) connecting the shielding region (23) of the connection carrier (20) to the rest of the connection carrier (20).

4. Optoelectronic device according to Claim 2 or 3, wherein the shielding region (23) and the rest of the connection carrier (20) form an angle (α) of less than or equal to 110° with one another.

5. Optoelectronic device according to Claim 1,
wherein the reflector wall or absorber wall (30) is embedded in a potting (21) for the at least one luminescence diode chip (1).

6. Optoelectronic device according to any of the preceding claims, comprising
- a housing base body (40) having a cavity (41), in which the at least one luminescence diode chip (1) is arranged, wherein
- the at least one shield (3) is formed by a shielding region (43) of the housing base body (40) at least in places.

7. Optoelectronic device according to the preceding claim,
wherein the shielding region (43) is injection-molded or transfer-molded together with the rest of the housing base body (40).

8. Optoelectronic device according to any of the preceding claims, comprising
- a lens (31, 50) for the at least one luminescence diode chip (1), wherein
- the at least one shield (3) is formed by a shielding region (33) of the lens (31, 50) at least in places.

9. Optoelectronic device according to the preceding claim,
wherein the lens (31, 50) is embodied in polarizing, absorbent and/or reflective fashion in the shielding region (53).

10. Optoelectronic device according to any of the preceding claims,
wherein the shield (3), at least in a reflection region (6) facing the at least one luminescence diode chip (1) is embodied as reflective to electromagnetic radiation (2) generated by the luminescence diode chip (1) during the operation of the optoelectronic device.

11. Optoelectronic device according to any of the preceding claims,
wherein the at least one shield (3), at least in an absorption region (7) facing the at least one luminescence diode chip (1) is embodied as absorbent to electromagnetic radiation (2) generated by the luminescence diode chip during the operation of the optoelectronic device.

12. Optoelectronic device according to any of the preceding claims,
wherein the at least one shield (3) has a curvature (5).

13. Optoelectronic device according to the preceding claim,
wherein the shield (3) is provided for diverting rainwater around a radiation exit area (8) of the optoelectronic device.

## Revendications

1. Composant optoélectronique (10), comprenant:
- au moins une puce à diode électroluminescente (1) qui, lors du fonctionnement du composant optoélectronique, émet un rayonnement électromagnétique (2);
- au moins un blindage (3) contre un rayonnement étranger (4), qui entoure latéralement, seulement en partie, la puce à diode électroluminescente (1),
- une paroi réfléchissante ou une paroi absorbante (30) qui entoure latéralement entièrement l'au moins une puce à diode électroluminescente (1), et
- un support de bornes (20) sur lequel est fixée au moins indirectement l'au moins une puce à diode électroluminescente (1) et par l'intermédiaire duquel un contact électrique est établi avec l'au moins une puce à diode électroluminescente (1),
dans lequel
- chaque blindage (3) est réalisé d'une seule pièce avec un composant (20, 30, 40, 50) du composant optoélectronique (10),
- la paroi réfléchissante ou la paroi absorbante (30) présente une hauteur (H) irrégulière,
- l'au moins un blindage (3) est formé au moins en partie par une région de blindage (33) de la paroi réfléchissante ou de la paroi absorbante (30), qui est réalisée à une plus grande hauteur que le reste de la paroi réfléchissante ou de la paroi absorbante (30),
- la paroi réfléchissante ou la paroi absorbante (30) est disposée à l'intérieur d'une lentille (31, 50) destinée à l'au moins une puce à diode électroluminescente (1),
- le support de bornes (20) est une carte de circuit imprimé, dans lequel la carte de circuit imprimé comprend un corps de base (32) électriquement isolé dans lequel ou sur lequel sont structurés des points de connexion et des pistes conductrices, et
- la paroi réfléchissante ou la paroi absorbante (30) est réalisée en une seule pièce avec le corps de base (32) réalisé de manière électriquement isolante.

2. Composant optoélectronique selon la revendication précédente, dans lequel
l'au moins un blindage (3) est formé au moins en partie par une région de blindage (23) du support de bornes (20).

3. Composant optoélectronique selon la revendication précédente,
dans lequel le support de bornes (20) présente un coude (24) qui relie la région de blindage (23) du support de bornes (20) au reste du support de bornes (20).

4. Composant optoélectronique selon la revendication 2 ou 3,
dans lequel la région de blindage (23) et le reste du support de bornes (20) délimitent l'un par rapport à l'autre un angle (α) inférieur ou égal à 110°.

5. Composant optoélectronique selon la revendication 1,
dans lequel la paroi réfléchissante ou la paroi absorbante (30) est incorporée à une encapsulation (21) de l'au moins une puce électroluminescente (1).

6. Composant optoélectronique selon l'une quelconque des revendications précédentes, comportant
- un corps de base de boîtier (40) qui comporte une cavité (41) dans laquelle est disposée au moins une puce électroluminescente (1), dans lequel
- l'au moins un blindage (3) est formé au moins en partie par une région de blindage (43) du corps de base de boîtier (40).

7. Composant optoélectronique selon la revendication précédente,
dans lequel la région de blindage (43) est moulée par injection ou moulée par transfert en association avec le reste du corps de base de boîtier (40).

8. Composant optoélectronique selon l'une quelconque des revendications précédentes, comportant
- une lentille (31, 50) pour l'au moins une puce électroluminescente (1), dans lequel
- l'au moins un blindage (3) est formé au moins en partie par une région de blindage (53) de la lentille (31, 50).

9. Composant optoélectronique selon la revendication précédente,
dans lequel la lentille (31, 50) est formée dans la région de blindage (53) de manière à être polarisante, absorbante et/ou réfléchissante.

10. Composant optoélectronique selon l'une quelconque des revendications précédentes,
dans lequel le blindage (3) est réalisé, au moins dans une région de réflexion (6) qui est opposée à l'au moins une puce de diode électroluminescente (1), de manière à être réfléchissant pour le rayonnement électromagnétique (2) généré par la puce de diode électroluminescente (1) lors du fonctionnement du composant optoélectronique.

11. Composant optoélectronique selon l'une quelconque des revendications précédentes,
dans lequel l'au moins un blindage (3) est réalisé dans au moins dans une région d'absorption (7) qui est opposée à l'au moins une puce de diode électroluminescente (1) de manière à être absorbant pour le rayonnement électromagnétique (2) généré par la puce de diode électroluminescente lors du fonctionnement du composant optoélectronique.

12. Composant optoélectronique selon l'une quelconque des revendications précédentes,
dans lequel l'au moins un blindage (3) présente une courbure (5).

13. Composant optoélectronique selon la revendication précédente,
dans lequel le blindage (3) est prévu pour dévier l'eau de pluie le long d'une surface de sortie de rayonnement (8) du composant optoélectronique.
